# EUROPÄISCHE PATENTANMELDUNG

(11) **EP 3 667 339 A1**
(43) Veröffentlichungstag der Anmeldung: **17.06.2020**
(21) Anmeldenummer: 18212685.4
(22) Anmeldetag: 14.12.2018
(51) Int. Cl.: G01R 31/02

(54) **ONLINE-KONTROLLE FÜR KONDENSATOREN VON KONDENSATORBÄNKEN**

(71) Anmelder: Siemens Aktiengesellschaft, 80333 München (DE)
(72) Erfinder: Hoffmann, Ingolf, 91074 Herzogenaurach (DE); Weiss, Roland, 91058 Erlangen (DE); Fleisch, Karl, 91054 Erlangen (DE); Kunert, Andreas, 90522 Oberasbach (DE)

(57) **Zusammenfassung**

Eine Kondensatorbatterie (1) weist mehrere Kondensatoren (2) auf, die über jeweilige Anschlüsse (3) in Reihenschaltung und/oder in Parallelschaltung miteinander vernetzt sind. Zumindest einige der Kondensatoren (2) weisen eine jeweilige Erfassungseinrichtung (5) auf. Die jeweilige Erfassungseinrichtung (5) wird über die Anschlüsse (3) des jeweiligen Kondensators (2) mit elektrischer Energie versorgt. Sie erfasst bei über die Anschlüsse (3) des jeweiligen Kondensators bestehender Energieversorgung mindestens einen aktuellen Betriebszustand (T1, T2, U, I) des jeweiligen Kondensators (2). Die jeweilige Erfassungseinrichtung (5) umfasst weiterhin eine jeweilige Sendeeinrichtung (15), über welche die jeweilige Erfassungseinrichtung (5) den jeweils erfassten Betriebszustand (T1, T2, U, I) des jeweiligen Kondensators (2) und/oder mindestens eine daraus abgeleitete Information (tR, δP) drahtlos an eine Auswertungseinrichtung (16) übermittelt.

## Beschreibung

Die vorliegende Erfindung geht aus von einer Kondensatorbatterie,
- wobei die Kondensatorbatterie eine Mehrzahl von Kondensatoren aufweist, die über jeweilige Anschlüsse in Reihenschaltung und/oder in Parallelschaltung miteinander vernetzt sind,
- wobei zumindest einige der Kondensatoren eine jeweilige Erfassungseinrichtung aufweisen,
- wobei die jeweilige Erfassungseinrichtung mindestens einen aktuellen Betriebszustand des jeweiligen Kondensators erfasst.

Die vorliegende Erfindung geht weiterhin aus von einem Gerät der Leistungselektronik,
- wobei das Gerät der Leistungselektronik eine Steuereinrichtung und eine von der Steuereinrichtung gesteuerte Einrichtung aufweist,
- wobei die gesteuerte Einrichtung eine derartige Kondensatorbatterie umfasst.

Geräte der Leistungselektronik umfassen oftmals Kondensatorbatterien, die ihrerseits eine Vielzahl von einzelnen Kondensatoren aufweisen, die nach Bedarf parallel und/oder in Reihe verschaltet sind.

Fällt einer der Kondensatoren der Kondensatorbatterie aus, ist die Funktion der Kondensatorbatterie und damit die Funktion des Geräts der Leistungselektronik zumindest beeinträchtigt. In vielen Fällen fällt sogar das gesamte Gerät der Leistungselektronik aus. Eine lange Lebensdauer und eine zuverlässige Erkennung eines drohenden Ausfalls eines Kondensators bereits im Vorfeld ist daher von erheblicher Bedeutung.

Im Stand der Technik ist es nicht üblich, die aktuellen Betriebszustände der Kondensatoren zu erfassen und zu verwerten. Dies gilt insbesondere für die Strombelastung der einzelnen Kondensatoren und die hiermit verbundene Verlustleistung. Stattdessen wird ein spezieller Versuchsaufbau erstellt, bei dem ein Muster der Kondensatorbatterie ohne Wechselwirkung mit dem Gerät der Leistungselektronik getestet wird. Aufbauend auf diesen Test wird eine Vorhersage für die erwartete Lebensdauer der Kondensatorbatterie getroffen.

Ein wesentlicher Nachteil dieser Vorgehensweise ist, dass insbesondere nur eine einzelne Kondensatorbatterie getestet wird und deren Testergebnisse als typisches Ergebnis auf andere Kondensatorbatterien übertragen wird. Damit können insbesondere Serienstreuungen, die stets auftreten können, nicht individuell mit berücksichtigt werden. Weiterhin erfolgt ein reiner Test in einer speziellen Testumgebung. Die tatsächlichen Daten beim Betrieb im Gerät der Leistungselektronik können nicht erfasst werden.

Die Gründe dafür, dass die aktuellen Betriebszustände der Kondensatoren nach dem Einbau in das Gerät der Leistungselektronik nicht verwertet werden, sind insbesondere, dass jeder Kondensator, dessen Betriebszustand erfasst werden soll, separat kontaktiert werden muss und derartige Kontakte zum einen Einfluss auf die Funktion des Kondensators als solches haben und zum anderen Probleme oftmals auch Probleme mit sich bringen, weil Spannungen oberhalb von 1 kV auftreten können, so dass erhebliche sicherheitstechnische Maßnahmen erforderlich sind.

Die Aufgabe der vorliegenden Erfindung besteht darin, Möglichkeiten zu schaffen, mittels derer die aktuellen Betriebszustände der Kondensatoren auf einfache Art und Weise im Betrieb erfasst werden können.

Die Aufgabe wird durch eine Kondensatorbatterie mit den Merkmalen des Anspruchs 1 gelöst. Vorteilhafte Ausgestaltungen der Kondensatorbatterie sind Gegenstand der abhängigen Ansprüche 2 bis 7.

Erfindungsgemäß wird eine Kondensatorbatterie der eingangs genannten Art dadurch ausgestaltet,
- dass die jeweilige Erfassungseinrichtung über die Anschlüsse des jeweiligen Kondensators mit elektrischer Energie versorgt wird,
- dass die jeweilige Erfassungseinrichtung den mindestens einen aktuellen Betriebszustand des jeweiligen Kondensators bei über die Anschlüsse des jeweiligen Kondensators bestehender Energieversorgung erfasst und
- dass die jeweilige Erfassungseinrichtung eine jeweilige Sendeeinrichtung umfasst, über welche die jeweilige Erfassungseinrichtung den jeweils erfassten Betriebszustand des jeweiligen Kondensators und/oder mindestens eine daraus abgeleitete Information drahtlos an eine Auswertungseinrichtung übermittelt.

Aufgrund der Energieversorgung über die Anschlüsse des jeweiligen Kondensators ist eine einfache Energieversorgung der Erfassungseinrichtung möglich. Soweit erforderlich, kann die Erfassungseinrichtung intern eine Pufferung vornehmen, beispielsweise über einen Gleichrichter mit nachgeordnetem Speicherkondensator. Dadurch ergibt sich die Möglichkeit, auch im laufenden realen Betrieb die entsprechende Erfassung des mindestens einen aktuellen Betriebszustands vorzunehmen. Aufgrund der drahtlosen Übermittlung des jeweils erfassten Betriebszustands und/oder der daraus abgeleiteten Information ist zum einen nicht das Verlegen von Leitungen als solches erforderlich und erfolgt zum anderen keinerlei Potenzialbeeinflussung des jeweiligen Kondensators.

Bezüglich des Betriebszustands und dessen Erfassung sind verschiedene Möglichkeiten gegeben.

Beispielsweise ist es möglich, dass die jeweilige Erfassungseinrichtung einen Temperatursensor umfasst, mittels dessen als aktueller Betriebszustand eine Betriebstemperatur des jeweiligen Kondensators erfasst wird.

Alternativ oder zusätzlich ist es möglich, dass die jeweilige Erfassungseinrichtung einen Temperatursensor umfasst, mittels dessen als aktueller Betriebszustand eine Umgebungstemperatur aus der Umgebung des jeweiligen Kondensators erfasst wird.

Alternativ oder zusätzlich ist es möglich, dass die jeweilige Erfassungseinrichtung einen Stromsensor umfasst, mittels dessen als aktueller Betriebszustand ein Ladestrom des jeweiligen Kondensators erfasst wird.

Der Stromsensor ist - sofern vorhanden - vorzugsweise derart ausgebildet, dass er sowohl einen Gleichanteil als auch einen Wechselanteil des jeweiligen Ladestroms erfasst. Ein Frequenzbereich, bis zu dem die Erfassung des Wechselanteils möglich ist, kann je nach Ausgestaltung des Stromsensors im Bereich etlicher Kilohertz liegen.

Weiterhin ist es - auch hier wieder alternativ oder zusätzlich - möglich, dass die jeweilige Erfassungseinrichtung einen Spannungssensor umfasst, mittels dessen als aktueller Betriebszustand eine an den Anschlüssen des jeweiligen Kondensators anstehende jeweilige Kondensatorspannung erfasst wird.

Die Kondensatoren selbst können nach Bedarf ausgebildet sein. Vorzugsweise sind zumindest einige der Kondensatoren, die eine jeweilige Erfassungseinrichtung aufweisen, als Elektrolytkondensatoren und/oder als Folienkondensatoren ausgebildet.

Die Aufgabe wird weiterhin durch ein Gerät der Leistungselektronik mit den Merkmalen des Anspruchs 8 gelöst.

Erfindungsgemäß wird ein Gerät der Leistungselektronik der eingangs genannten Art dadurch ausgestaltet,
- dass die Steuereinrichtung einen Empfänger aufweist, der die von den Erfassungseinrichtungen der Kondensatoren übermittelten Betriebszustände der Kondensatoren und/oder die daraus abgeleiteten Informationen empfängt und
- dass die Steuereinrichtung die an sie übermittelten Betriebszustände und/oder die daraus abgeleiteten Informationen im Rahmen der Ansteuerung der gesteuerten Einrichtung berücksichtigt.

Dadurch ist auf einfache Weise eine Verwertung der mittels der Erfassungseinrichtungen erfassten Betriebszustände möglich.

In vielen Fällen ist die gesteuerte Einrichtung als Frequenzumrichter ausgebildet.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: ein Blockschaltbild einer Kondensatorbatterie,
- FIG 2: den konstruktiven Aufbau einer Kondensatorbatterie,
- FIG 3: ein Blockschaltbild eines Kondensators,
- FIG 4: einen Schnitt durch einen Kondensator und
- FIG 5: ein Gerät der Leistungselektronik.

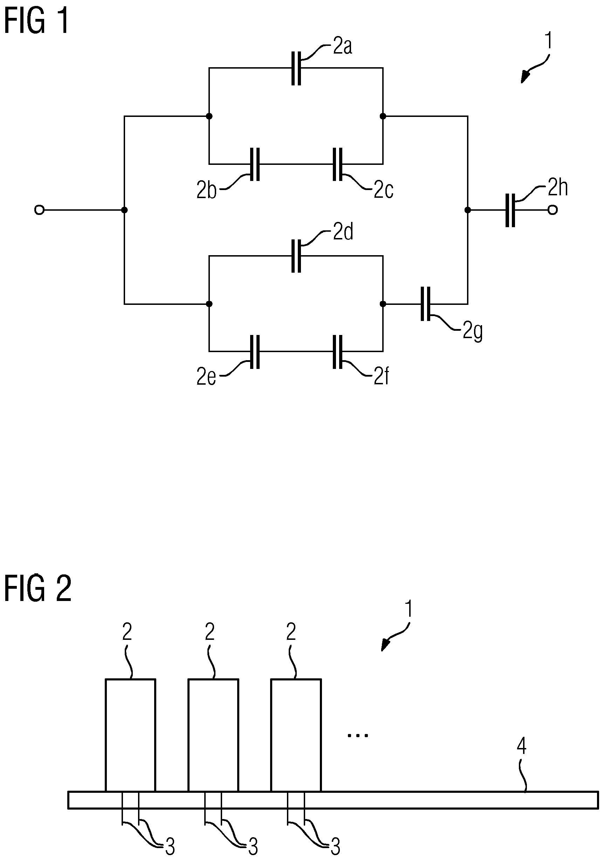

Gemäß FIG 1 weist eine allgemein mit dem Bezugszeichen 1 versehene Kondensatorbatterie eine Mehrzahl von Kondensatoren 2 auf. Die Anzahl an Kondensatoren 2 kann nach Bedarf sein. Die in FIG 1 dargestellte Anzahl von insgesamt acht Kondensatoren 2 ist rein beispielhaft. Die Bezugszeichen für die Kondensatoren 2 sind in FIG 1 mit einem kleinen Buchstaben (a bis h) ergänzt, um sie bei Bedarf anhand ihres Bezugszeichen voneinander unterscheiden zu können. Soweit nachstehend allgemein das Bezugszeichen 2 - also ohne Ergänzung durch einen kleinen Buchstaben - verwendet wird, ist von den Kondensatoren 2 allgemein die Rede. Soweit auf spezifisch auf einen bestimmten der Kondensatoren 2 Bezug genommen werden soll, wird das Bezugszeichen 2 durch den entsprechenden kleinen Buchstaben ergänzt.

Die Kondensatoren 2 weisen gemäß FIG 2 jeweils zwei Anschlüsse 3 auf. Über die Anschlüsse 3 sind die Kondensatoren 2 miteinander vernetzt. Die Vernetzung der Kondensatoren 2 miteinander ist hierbei nach Bedarf in Reihenschaltung und/oder in Parallelschaltung. Im einfachsten Fall ist die Vernetzung der Kondensatoren 2 miteinander entweder eine reine Reihenschaltung oder eine reine Parallelschaltung. Es sind aber auch andere Verschaltungen möglich. Beispielsweise ist in der konkreten Ausgestaltung gemäß FIG 2 dem Kondensator 2a die Reihenschaltung der Kondensatoren 2b und 2c parallel geschaltet. In analoger Weise ist in der konkreten Ausgestaltung gemäß FIG 2 dem Kondensator 2d die Reihenschaltung der Kondensatoren 2e und 2f parallel geschaltet. Der Verschaltung der Kondensatoren 2d bis 2f wiederum ist in der konkreten Ausgestaltung gemäß FIG 2 der Kondensator 2g in Reihe geschaltet, wobei die Verschaltung der Kondensatoren 2a bis 2c und die Verschaltung der Kondensatoren 2d bis 2g einander parallel geschaltet sind. Zu diesen beiden Schaltungen ist in der konkreten Ausgestaltung gemäß FIG 2 wiederum der Kondensator 2h in Reihe geschaltet.

Die Darstellung in FIG 1 ist rein beispielhaft. Es können auch andere Verschaltungen realisiert sein.

In der Regel sind die Kondensatoren 2 entsprechend der Darstellung in FIG 2 auf einer Leiterplatte 4 angeordnet. Mittels der Leiterplatte 4 wird zum einen eine mechanisch stabile Anordnung der Kondensatoren 2 gewährleistet. Zum anderen wird - zumindest in der Regel - mittels der Leiterplatte 4 die konkrete Verschaltung bzw. Vernetzung der Kondensatoren 2 miteinander realisiert.

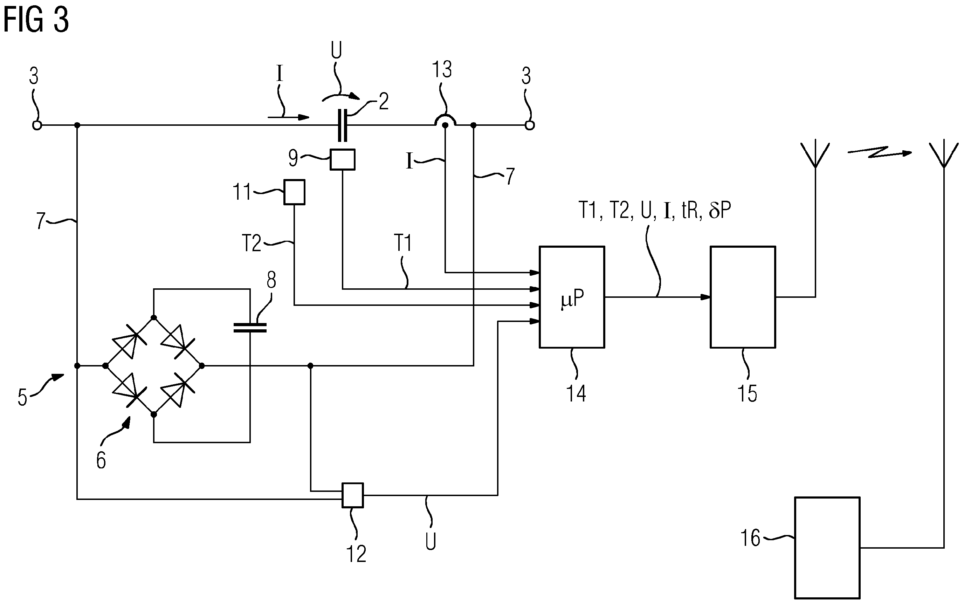

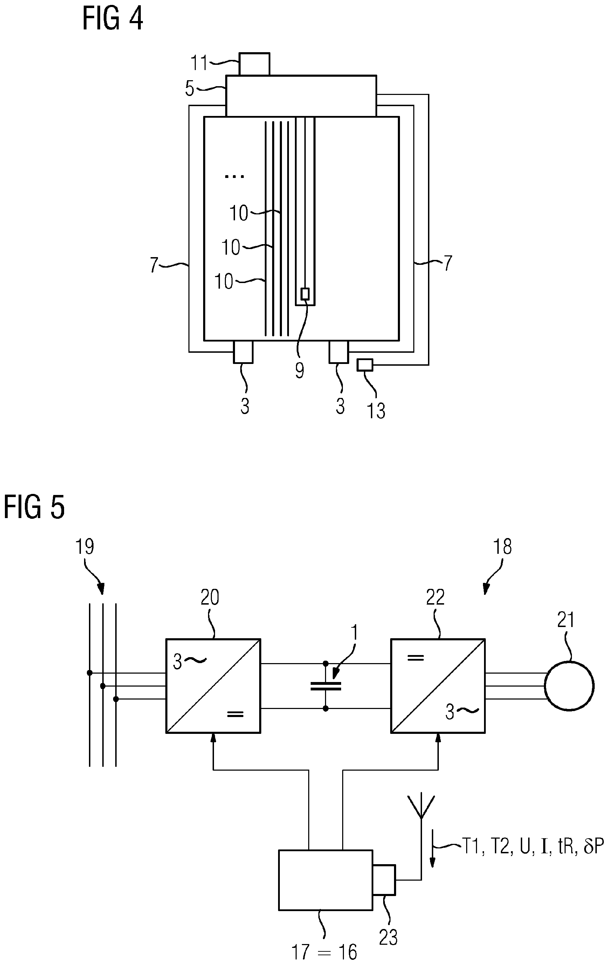

Nachfolgend wird in Verbindung mit den FIG 3 und 4 der Aufbau eines einzelnen Kondensators 2 erläutert. Nachfolgend ist daher stets in Verbindung mit den FIG 3 und 4 nur noch von einem einzelnen Kondensator 2 die Rede. In der Regel sind alle Kondensatoren 2 derart ausgebildet. Zumindest bei einigen der Kondensatoren 2 - also mehreren der Kondensatoren 2 - ist die nachstehend erläuterte Ausgestaltung jedoch realisiert.

Gemäß den FIG 3 und 4 weist der Kondensator 2 eine Erfassungseinrichtung 5 auf. Die Erfassungseinrichtung 5 arbeitet nur dann, wenn sie mit elektrischer Energie versorgt wird. Die Versorgung der Erfassungseinrichtung 5 mit elektrischer Energie erfolgt über die Anschlüsse 3 des Kondensators 2. Beispielsweise kann die Erfassungseinrichtung 5 einen Brückengleichrichter 6 aufweisen, der über Leitungen 7 mit den Anschlüssen 3 verbunden ist. Dem Brückengleichrichter 6 kann beispielsweise ein Pufferkondensator 8 nachgeordnet sein, damit kurzzeitige Unterbrechungen der Energieversorgung - wenn an dem Kondensator 2 eine Wechselspannung anliegt, beispielsweise beim Nulldurchgang der über dem Kondensator 2 abfallenden Kondensatorspannung U - keine Auswirkungen auf die Energieversorgung der Erfassungseinrichtung 5 haben. Es sind aber auch andere Ausgestaltungen möglich.

Immer wenn die Erfassungseinrichtung 5 über die Anschlüsse 3 des Kondensators 2 mit elektrischer Energie versorgt wird, erfasst die Erfassungseinrichtung 5 mindestens einen aktuellen Betriebszustand T1, T2, U, I des Kondensators 2.

Beispielsweise kann die Erfassungseinrichtung 5 einen Temperatursensor 9 umfassen. Der Temperatursensor 9 erfasst, sofern er vorhanden ist, als aktuellen Betriebszustand eine Betriebstemperatur T1 des Kondensators 2. Zu diesem Zweck ist der Temperatursensor 9 entsprechend der Darstellung in FIG 4 vorzugsweise im Inneren des Kondensators 2 angeordnet. Beispielsweise kann der Kondensator 2 entsprechend der Darstellung in FIG 4 als Elektrolytkondensator und/oder als Folienkondensator ausgebildet sein. FIG 4 zeigt in der linken Hälfte einzelne Lagen 10 der Wicklung des Kondensators 2.

Alternativ oder zusätzlich kann die Erfassungseinrichtung 5 einen Temperatursensor 11 umfassen. Der Temperatursensor 11 erfasst, sofern er vorhanden ist, als aktuellen Betriebszustand eine Temperatur T2 aus der Umgebung des Kondensators 2, also die Umgebungstemperatur.

Alternativ oder zusätzlich kann die Erfassungseinrichtung 5 einen Spannungssensor 12 umfassen. Der Spannungssensor 12 erfasst, sofern er vorhanden ist, als aktuellen Betriebszustand die an den Anschlüssen 3 anstehende Kondensatorspannung U. Die Kondensatorspannung U kann direkt über die Anschlüsse 3 abgegriffen werden. Alternativ ist beispielsweise ein Abgreifen über die Leitungen 7 möglich.

Alternativ oder zusätzlich kann die Erfassungseinrichtung 5 einen Stromsensor 13 umfassen. Der Stromsensor 13 erfasst, sofern er vorhanden ist, als aktuellen Betriebszustand einen über die Anschlüsse 3 fließenden Ladestrom I. Der Stromsensor 13 ist, sofern er vorhanden ist, vorzugsweise derart ausgebildet, dass er sowohl einen Gleichanteil als auch einen Wechselanteil des jeweiligen Ladestroms erfasst. Derartige Ausgestaltungen sind Fachleuten allgemein bekannt.

Die erfassten Betriebszustände T1, T2, U, I werden einer Verarbeitungseinrichtung 14 der Erfassungseinrichtung 5 zugeführt. Die Verarbeitungseinrichtung 14 kann beispielsweise einen Mikroprozessor oder einen Mikrocontroller aufweisen. Die Verarbeitungseinrichtung 14 nimmt zumindest eine kurzzeitige Zwischenspeicherung der erfassten Betriebszustände T1, T2, U, I vor. Weiterhin steuert die Verarbeitungseinrichtung 14 eine Sendeeinrichtung 15 der Erfassungseinrichtung 5 an, so dass die Sendeeinrichtung 15 drahtlos Daten an eine Auswertungseinrichtung 16 übermittelt. Die Übermittlung kann beispielsweise gemäß dem Bluetooth-Standard, gemäß dem WiFi-Standard oder in einer Frequenz des ISM-Bandes erfolgen. Auch andere Frequenzbereiche und andere Übermittlungsverfahren sind möglich. Beispiele derartiger Frequenzbereiche und Übermittlungsverfahren sind 6LoWPAN, ZigBee, Z-Wave, SmartMeshIP und andere mehr.

Es ist möglich, dass die Verarbeitungseinrichtung 14 der Sendeeinrichtung 15 als zu sendende Daten die erfassten Betriebszustände T1, T2, U, I vorgibt. In diesem Fall sendet die Sendeeinrichtung 15 die erfassten Betriebszustände T1, T2, U, I aus. Es ist weiterhin möglich, dass die Verarbeitungseinrichtung 14 eine Verarbeitung der erfassten Betriebszustände T1, T2, U, I vornimmt und dadurch aus den erfassten Betriebszuständen T1, T2, U, I Informationen ableitet. Beispielsweise kann die Verarbeitungseinrichtung 14 unter Verwertung der erfassten Betriebszustände T1, T2, U, I eine erwartete Restlebensdauer tR des Kondensators 2 oder die Verlustleistung δP des Kondensators 2 ermitteln. In diesem Fall kann die Verarbeitungseinrichtung 14 der Sendeeinrichtung 15 - alternativ oder zusätzlich zu den erfassten Betriebszuständen T1, T2, U, I - die abgeleiteten Informationen tR, δP als zu sendende Daten vorgeben. In diesem Fall sendet die Sendeeinrichtung 15 die abgeleiteten Informationen tR, δP aus.

Die Kondensatorbatterie 1 ist in der Regel entsprechend der Darstellung in FIG 5 Bestandteil eines Gerätes der Leistungselektronik. Das Gerät der Leistungselektronik weist in diesem Fall eine Steuereinrichtung 17 und eine von der Steuereinrichtung 17 gesteuerte Einrichtung 18 auf. Die Kondensatorbatterie 1 ist Bestandteil der gesteuerten Einrichtung 18. Die Kondensatorbatterie 1 ist so ausgebildet, wie dies oben stehend in Verbindung mit den FIG 1 bis 4 erläutert wurde.

Die gesteuerte Einrichtung 18 kann nach Bedarf ausgebildet sein. Entsprechend der Darstellung in FIG 5 ist die gesteuerte Einrichtung 18 als Frequenzumrichter ausgebildet. Diese Ausgestaltung ist aber nur rein beispielhaft. Auch die konkrete Ausgestaltung des Frequenzumrichters mit einem eingangsseitigen, aus einem Versorgungsnetz 19 gespeisten Gleichrichter 20, einem ausgangsseitigen, eine Last 21 speisenden Wechselrichter 22 und einer Anordnung der Kondensatorbatterie 1 zwischen dem eingangsseitigen Gleichrichter 20 und dem ausgangsseitigen Wechselrichter 22 ist nur rein beispielhaft.

Die Steuereinrichtung 17 weist gemäß der Darstellung in FIG 5 einen Empfänger 23 auf. Der Empfänger 23 empfängt von den Erfassungseinrichtungen 5 der Kondensatoren 2 diejenigen Daten, welche von den Sendeeinrichtungen 15 der Erfassungseinrichtungen 5 ausgesendet werden. Der Empfänger 23 empfängt also - je nachdem, welche Daten die Sendeeinrichtungen 15 aussenden - die erfassten Betriebszustände T1, T2, U, I und/oder die daraus abgeleiteten Informationen tR, δP.

Die Steuereinrichtung 17 wertet die an sie übermittelten Betriebszustände T1, T2, U, I und/oder die daraus abgeleiteten Informationen tR, δP aus und berücksichtigt das Ergebnis ihrer Auswertung im Rahmen der Ansteuerung der gesteuerten Einrichtung 18. Die Steuereinrichtung 17 übernimmt also die Funktion der Auswertungseinrichtung 16 von FIG 3. Dies ist in FIG 5 durch die Gleichsetzung der Steuereinrichtung 17 mit der Auswertungseinrichtung 16 angedeutet.

Zusammengefasst betrifft die vorliegende Erfindung somit folgenden Sachverhalt:
Eine Kondensatorbatterie 1 weist mehrere Kondensatoren 2 auf, die über jeweilige Anschlüsse 3 in Reihenschaltung und/oder in Parallelschaltung miteinander vernetzt sind. Zumindest einige der Kondensatoren 2 weisen eine jeweilige Erfassungseinrichtung 5 auf. Die jeweilige Erfassungseinrichtung 5 wird über die Anschlüsse 3 des jeweiligen Kondensators 2 mit elektrischer Energie versorgt. Sie erfasst bei über die Anschlüsse 3 des jeweiligen Kondensators bestehender Energieversorgung mindestens einen aktuellen Betriebszustand T1, T2, U, I des jeweiligen Kondensators 2. Die jeweilige Erfassungseinrichtung 5 umfasst weiterhin eine jeweilige Sendeeinrichtung 15, über welche die jeweilige Erfassungseinrichtung 5 den jeweils erfassten Betriebszustand T1, T2, U, I des jeweiligen Kondensators 2 und/oder mindestens eine daraus abgeleitete Information tR, δP drahtlos an eine Auswertungseinrichtung 16 übermittelt.

Die vorliegende Erfindung weist viele Vorteile auf. Beispielsweise kann anhand der erfassten Betriebszustände T1, T2, U, I des jeweiligen Kondensators 2 und/oder der mindestens einen daraus abgeleiteten Information tR, δP des jeweiligen Kondensators 2 rechtzeitig vorher erkannt werden, wenn ein Ausfall des jeweiligen Kondensators 2 droht. Weiterhin kann durch entsprechende Ansteuerung der gesteuerten Einrichtung 18 eventuell sogar eine Vergleichmäßigung der Belastung der einzelnen Kondensatoren 2 reicht werden. In diesem Fall kann die Lebensdauer der Kondensatoren 2 vereinheitlicht werden und damit die Lebensdauer der Kondensatorbatterie 1 als Einheit maximiert werden. Eine potenzialgetrennte Erfassung der Betriebszustände T1, T2, U, I der Kondensatoren 2 ist ohne weiteres möglich. Die erfassten Betriebszustände T1, T2, U, I stehen quasi online, kontinuierlich und in Echtzeit zur Verfügung.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Kondensatorbatterie,
- wobei die Kondensatorbatterie eine Mehrzahl von Kondensatoren (2) aufweist, die über jeweilige Anschlüsse (3) in Reihenschaltung und/oder in Parallelschaltung miteinander vernetzt sind,
- wobei zumindest einige der Kondensatoren (2) eine jeweilige Erfassungseinrichtung (5) aufweisen,
- wobei die jeweilige Erfassungseinrichtung (5) über die Anschlüsse (3) des jeweiligen Kondensators (2) mit elektrischer Energie versorgt wird,
- wobei die jeweilige Erfassungseinrichtung (5) bei über die Anschlüsse (3) des jeweiligen Kondensators bestehender Energieversorgung mindestens einen aktuellen Betriebszustand (T1, T2, U, I) des jeweiligen Kondensators (2) erfasst und
- wobei die jeweilige Erfassungseinrichtung (5) eine jeweilige Sendeeinrichtung (15) umfasst, über welche die jeweilige Erfassungseinrichtung (5) den jeweils erfassten Betriebszustand (T1, T2, U, I) des jeweiligen Kondensators (2) und/ oder mindestens eine daraus abgeleitete Information (tR, δP) drahtlos an eine Auswertungseinrichtung (16) übermittelt.

2. Kondensatorbatterie nach Anspruch 1,
**dadurch gekennzeichnet,**
**dass** die jeweilige Erfassungseinrichtung (5) einen Temperatursensor (9) umfasst, mittels dessen als aktueller Betriebszustand (T1) eine Betriebstemperatur (T1) des jeweiligen Kondensators (2) erfasst wird.

3. Kondensatorbatterie nach Anspruch 1 oder 2,
**dadurch gekennzeichnet,**
**dass** die jeweilige Erfassungseinrichtung (5) einen Temperatursensor (11) umfasst, mittels dessen als aktueller Betriebszustand (T2) eine Umgebungstemperatur (T2) aus der Umgebung des jeweiligen Kondensators (2) erfasst wird.

4. Kondensatorbatterie nach Anspruch 1, 2 oder 3,
**dadurch gekennzeichnet,**
**dass** die jeweilige Erfassungseinrichtung (5) einen Stromsensor (13) umfasst, mittels dessen als aktueller Betriebszustand (I) ein Ladestrom (I) des jeweiligen Kondensators (2) erfasst wird.

5. Kondensatorbatterie nach Anspruch 4,
**dadurch gekennzeichnet,**
**dass** der Stromsensor (13) derart ausgebildet ist, dass er sowohl einen Gleichanteil als auch einen Wechselanteil des jeweiligen Ladestroms (I) erfasst.

6. Kondensatorbatterie nach einem der obigen Ansprüche,
**dadurch gekennzeichnet,**
**dass** die jeweilige Erfassungseinrichtung (5) einen Spannungssensor (12) umfasst, mittels dessen als aktueller Betriebszustand (U) eine an den Anschlüssen (3) des jeweiligen Kondensators (2) anstehende jeweilige Kondensatorspannung (U) erfasst wird.

7. Kondensatorbatterie nach einem der obigen Ansprüche,
**dadurch gekennzeichnet,**
**dass** zumindest einige der Kondensatoren (2), die eine jeweilige Erfassungseinrichtung (5) aufweisen, als Elektrolytkondensatoren und/oder als Folienkondensatoren ausgebildet sind.

8. Gerät der Leistungselektronik,
- wobei das Gerät der Leistungselektronik eine Steuereinrichtung (17) und eine von der Steuereinrichtung (17) gesteuerte Einrichtung (18) aufweist,
- wobei die gesteuerte Einrichtung (18) eine Kondensatorbatterie (1) nach einem der obigen Ansprüche umfasst,
**dadurch gekennzeichnet,**
- **dass** die Steuereinrichtung (17) einen Empfänger (23) aufweist, der die von den Erfassungseinrichtungen (5) der Kondensatoren (2) übermittelten Betriebszustände (T1, T2, U, I) der Kondensatoren (2) und/oder die daraus abgeleiteten Informationen (tR, δP) empfängt und
- **dass** die Steuereinrichtung (17) die an sie übermittelten Betriebszustände (T1, T2, U, I) und/oder die daraus abgeleiteten Informationen (tR, δP) im Rahmen der Ansteuerung der gesteuerten Einrichtung (18) berücksichtigt.

9. Gerät der Leistungselektronik nach Anspruch 8,
**dadurch gekennzeichnet,**
**dass** die gesteuerte Einrichtung (18) als Frequenzumrichter ausgebildet ist.
